# EUROPEAN PATENT APPLICATION

(11) **EP 2 796 823 A2**
(43) Date of publication of application: **29.10.2014**
(21) Application number: 13189433.9
(22) Date of filing: 18.10.2013
(51) Int. Cl.: F28F 3/02

(54) **Heat sink incorporating interlocked fin**

(30) Priority: 24.04.2013 CN 201310144414
(71) Applicant: Champ Tech Optical (FOSHAN) Corporation, Foshan Guangdong (CN); Foxconn Technology Co., Ltd, Taipei Hsien (TW)
(72) Inventor: Yan, Qiang, Foshan Guangdong (CN); Qin, Ji-Yun, Foshan Guangdong (CN)
(74) Representative: Gray, John James

(57) **Abstract**

An exemplary heat sink (100) includes a plurality of fins (10) interconnected together. Each of the fins includes a main body (12) and at least an engaging portion (14) extending outwardly from the main body (10). The engaging portions (14) of every two adjacent fins (10) are interlocked with each other. The engaging portion (14) includes a base (140) extending outwardly from the main body (12), an engaging groove (142) defined at a lateral side of the base (140), and an inserting rib (144) protruding outwardly from another lateral side of the base (140) opposite to the engaging groove (142). In the two adjacent fins (10), the inserting rib (144) of the engaging portion (14) of one fin (10) is fitly inserted into the engaging groove (142) of the engaging portion (14) of another fin (10).

## Description

### BackGround

### Field

The present disclosure relates to heat sinks, more particularly to a heat sink incorporating a plurality of interlocked fins.

### BackGround

It is well known that during operation of a computer, electronic component thereof such as a central processing unit (CPU) generates large amounts of heat. The generated heat must be quickly removed from the electronic component to prevent it from becoming unstable or being damaged. Generally, a heat sink is attached to the electronic component for a cooling purpose. A typical heat sink includes a base plate and a plurality of fins extending from the base plate. The base plate is attached to the electronic component to absorb heat from the electronic component, and the heat absorbed by the base plate is then dissipated to ambient air via the fins. However, the fins are easily disengaged from the adjacent fins when the assembled fins are subject to mechanical shocks.

What is needed, therefore, is an improved heat sink which overcomes the above described shortcomings.

### Summary

An exemplary heat sink includes a plurality of fins interconnected together. Each of the fins includes a main body and at least an engaging portion extending outwardly from the main body. The engaging portions of every two adjacent fins are interlocked with each other. The engaging portion includes a base extending outwardly from the main body, an engaging groove defined at a lateral side of the base, and an inserting rib protruding outwardly from another lateral side of the base opposite to the engaging groove. In the two adjacent fins, the inserting rib of the engaging portion of one fin is fitly inserted into the engaging groove of the engaging portion of another fin.

### BRIEF DESCRIPTION OF THE DRAWINGS

FIG. 1 is an isometric, assembled view of a heat sink according to a first embodiment of the present disclosure.

FIG. 2 is an exploded, isometric view of the heat sink of FIG. 1.

FIG. 3 is an enlarged view of a circle portion III of FIG. 2.

FIG. 4 is a lateral-side view of the heat sink of FIG. 1.

FIG. 5 is a lateral-side view of a heat sink according to a second embodiment of the present disclosure.

FIG. 6 is an enlarged view of a circle portion VI of FIG. 5.

### DETAILED DESCRIPTION

An embodiment of a heat sink in accordance with the present disclosure will now be described in detail below and with reference to the drawings.

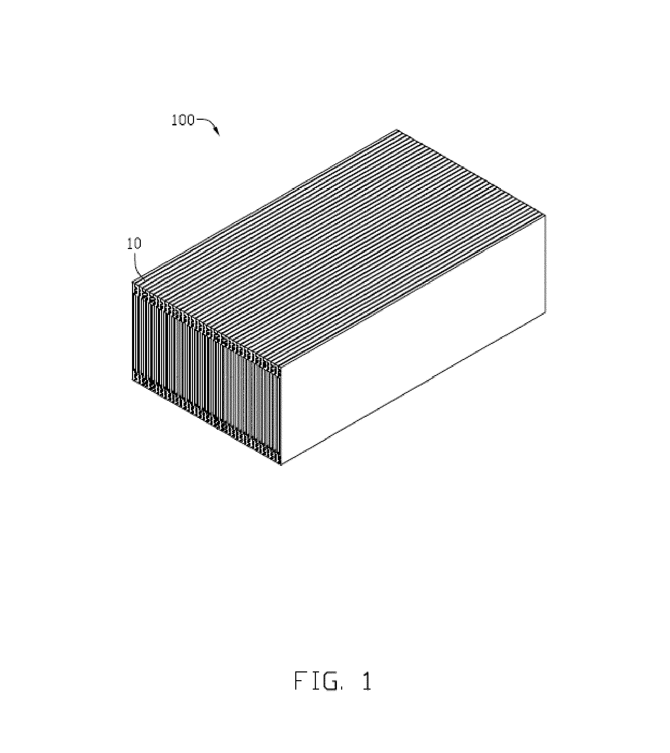

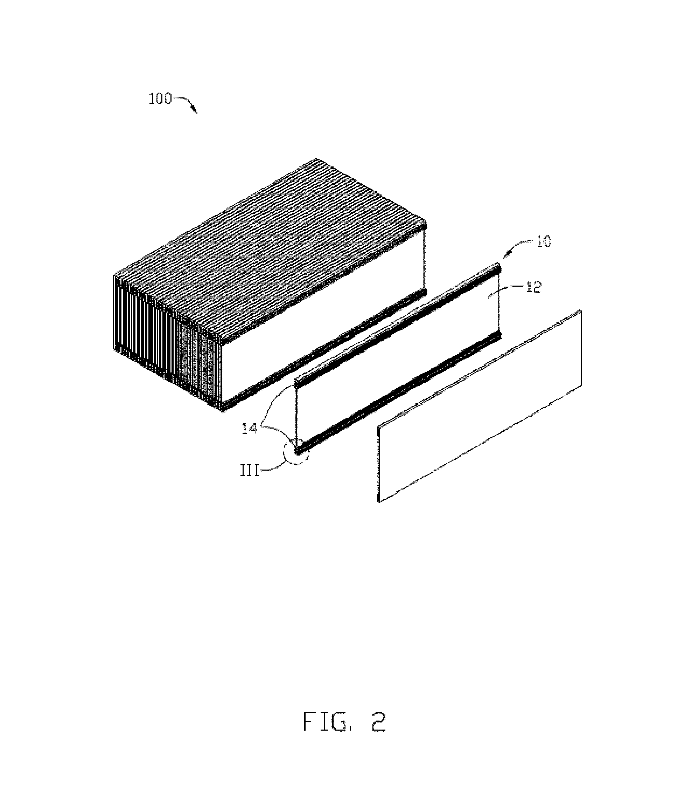

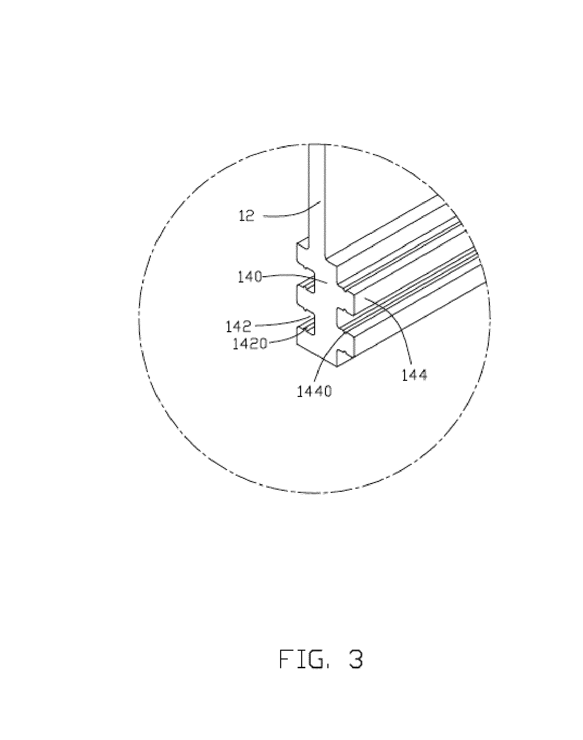

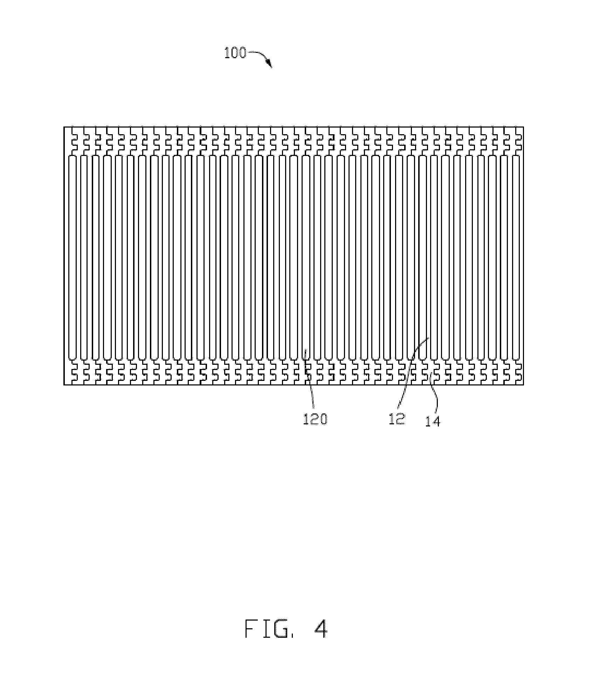

Referring to FIGS. 1-4, a heat sink 100 in accordance with a first embodiment of the disclosure is illustrated. The heat sink 100 includes a plurality of interlocked fins 10. A bottom surface of the heat sink 100 is for thermally contacting an electronic component (not shown) mounted on a printed circuit board (not shown) to dissipate heat generated by the electronic component.

Each of the fins 10 includes a main body 12 and a pair of engaging portions 14 extending outwardly from top and bottom ends of the main body 12, respectively. In every two adjacent fins 10, the engaging portions 14 of one fin 10 are correspondingly interlocked with the engaging portions 14 of another fin 10. Each engaging portion 14 includes a base 140 extending from the main body 12, at least an engaging groove 142 defined at a lateral side of the base 140, and at least an inserting rib 144 protruding outwardly from another lateral side of the base 140 opposite to the engaging groove 142. The engaging groove 142 and the inserting rib 144 both extend along a lengthways direction of the fin 10. The inserting rib 144 has a configuration in complement with that of the engaging groove 142. The number and position of the inserting rib 144 are corresponding to those of the engaging groove 142. In every two adjacent fins 10, the inserting rib 144 of the engaging portion 14 of one fin 10 is fitly inserted into the engaging groove 142 of the engaging portion 14 of another fin 10. In this embodiment of the disclosure, there are two engaging grooves 142 and two inserting ribs 144 formed on two opposite lateral sides of each engaging portion 14 of the fin 10, respectively. A cross section of the inserting rib 144 is rectangular. The main bodies 12 of the fins 10 are parallel to and spaced from each other. A flow channel 120 is defined between the main bodies 12 of every two adjacent fins 10.

In each fin 10, each engaging portion 14 further includes at least a cutout 1440 recessed inwardly from an outer periphery of the inserting rib 144, and a protruding block 1420 formed in the engaging groove 142. The protruding block 1420 has a configuration in complement with that of the cutout 1440. The number and position of the protruding block 1420 are both corresponding to those of the cutout 1440. In this embodiment of the disclosure, there are two protruding blocks 1420 formed in the engaging groove 142 opposite to each other, and two cutouts 1440 formed in two opposite sides of the inserting rib 144, respectively. A cross section of the protruding block 1420 is semicircular. The protruding block 1420 extends along a direction which the engaging groove 142 extends along. The cutout 1440 extends along a direction which the inserting rib 144 extends along. In every two adjacent fins 10, the inserting rib 144 of the engaging portion 14 of one fin 10 is fitly inserted into the engaging groove 142 of the engaging portion 14 of another fin 10, and the protruding block 1420 is correspondingly stuck in the cutout 1440.

Alternatively, the protruding block 1420 could also be formed on the outer periphery of the inserting rib 144, and the cutout 1440 is correspondingly formed in the engaging groove 142.

The engaging portions 14 of the fins 10 of the heat sink 100 are aligned with and coplanar with each other, whereby a bottom/top face of the heat sink 100 is planar.

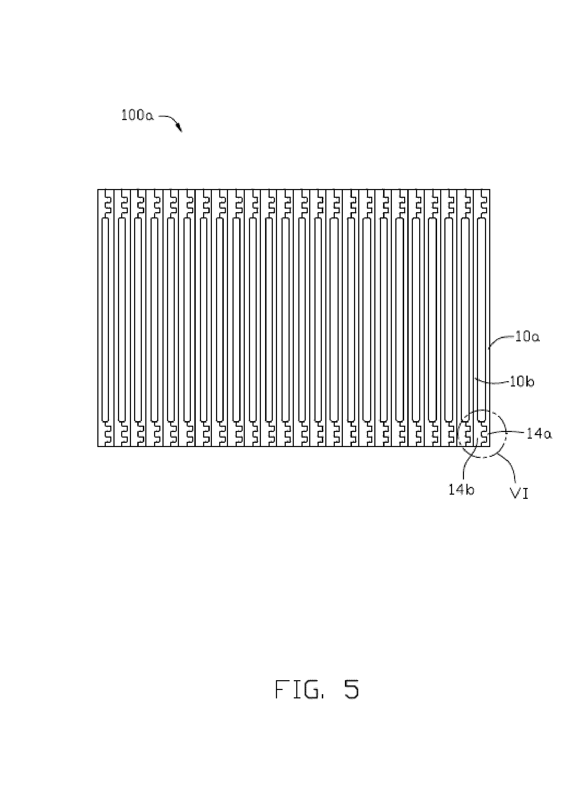

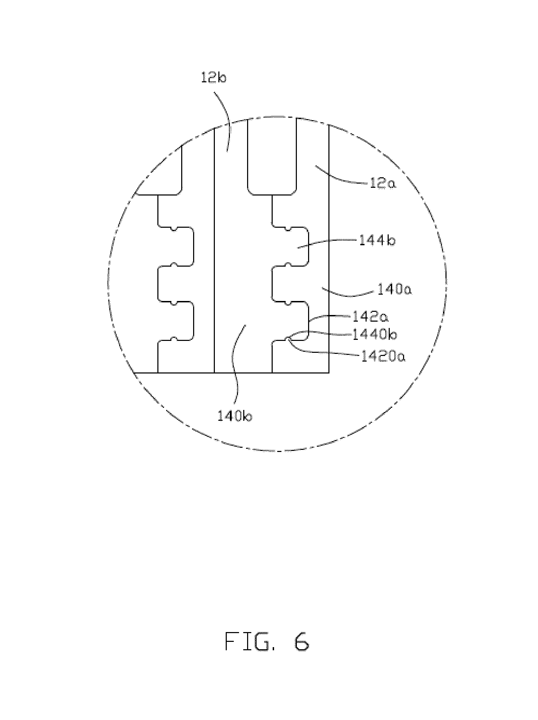

Referring to FIGS. 5 and 6 also, a heat sink 100a in accordance with a second embodiment of the disclosure is illustrated. The heat sink 100a includes a first fin 10a, and a second fin 10b interlocked with the first fin 10a. The first fin 10a includes a first main body 12a and a pair of first engaging portions 14a extending outwardly from top and bottom ends of the first main body 12a, respectively. The second fin 10b includes a second main body 12b and a pair of second engaging portions 14b extending outwardly from top and bottom ends of the second main body 12b, respectively. The first engaging portions 14a of the first fin 10a are correspondingly interlocked with the second engaging portions 14b of the second fin 10b.

The first engaging portion 14a includes a first base 140a extending from the first main body 12a, at least a first engaging groove 142a defined at a lateral side of the first base 140a. The second engaging portion 14b includes a second base 140b extending from the second main body 12b, and at least a second inserting rib 144b protruding outwardly from a lateral side of the second base 140b. The second inserting rib 144b has a configuration in complement with that of the first engaging groove 142a. The number and position of the second inserting rib 144b are corresponding to those of the first engaging groove 142a. In assembly, the second inserting rib 144b of second fin 10b is fitly inserted into the first engaging groove 142a of the first fin 10a. A cross section of the second inserting rib 144b is rectangular. The first engaging groove 142a extends along a lengthways direction of the first fin 10a. The second inserting rib 144b extends along a lengthways direction of the second fin 10b.

In the first fin 10a, the first engaging portion 14a further includes at least a first protruding block 1420a formed in the first engaging groove 142a. In the second fin 10b, the first engaging portion 14a further includes at least a second cutout 1440b recessed inwardly from an outer periphery of the second inserting rib 144b. The first protruding block 1420a has a configuration in complement with that of the second cutout 1440b. The number and position of the first protruding block 1420a are both corresponding to those of the second cutout 1440b. A cross section of the first protruding block 1420a is semicircular. The first protruding block 1420a extends along a direction which the first engaging groove 142a extends along. The second cutout 1440b extends along a direction which the second inserting rib 144b extends along. In assembly, the second inserting rib 144b of second fin 10b is fitly inserted into the first engaging groove 142a of the first fin 10a, and the first protruding block 1420a is correspondingly stuck in the second cutout 1440b.

Alternatively, the first protruding block 1420a could also be formed on the outer periphery of the second inserting rib 144b of the second fin 10b, and the second cutout 1440b is correspondingly formed in the first engaging groove 142a of the first fin 10a.

It is to be further understood that even though numerous characteristics and advantages of the present embodiments have been set forth in the foregoing description, together with details of the structures and functions of the embodiments, the disclosure is illustrative only, and changes may be made in detail, especially in matters of shape, size, and arrangement of parts within the principles of the disclosure to the full extent indicated by the broad general meaning of the terms in which the appended claims are expressed.

## Claims

1. A heat sink comprising:
a plurality of fins interconnected together, each of the fins comprising:
a main body; and
at least an engaging portion extending outwardly from the main body, wherein
the engaging portions of every two adjacent fins are interlocked with each other;
wherein the engaging portion comprises a base extending outwardly from the main body, an engaging groove defined at a lateral side of the base, and an inserting rib protruding outwardly from another lateral side of the base opposite to the engaging groove, and in the two adjacent fins, the inserting rib of the engaging portion of one fin is fitly inserted into the engaging groove of the engaging portion of another fin.

2. The heat sink as claimed in claim 1, wherein a pair of engaging portions extending outwardly from top and bottom ends of each fin, respectively .

3. The heat sink as claimed in claim 1 or 2, wherein the engaging portion extends along a lengthways direction of the fin.

4. The heat sink as claimed in claim 1, 2 or 3, wherein the inserting rib extends along a lengthways direction of the fin.

5. The heat sink as claimed in any preceding claim, wherein the inserting rib has a configuration in complement with that of the engaging groove.

6. The heat sink as claimed in any preceding claim, wherein the engaging portion further comprises a protruding block formed in the engaging groove.

7. The heat sink as claimed in claim 6, wherein the engaging portion further comprises a cutout recessed inwardly from an outer periphery of the inserting rib, and in the two adjacent fins, the protruding block has a configuration in complement with that of the cutout, the protruding block of the engaging portion of the one fin is stuck in the cutout of the engaging portion of the another fin.

8. The heat sink as claimed in claim 7, wherein the protruding block extends along a direction the engaging groove extends along, and the cutout extends along a direction which the inserting rib extends along.

9. A heat sink comprising:
a first fin comprising a first main body and a first engaging portion extending outwardly from the first main body, and the first engaging portion comprising a first base extending from the first main body, and an engaging groove defined at a lateral side of the first base; and
a second fin interlocked with the first fin, the second fin comprising a second main body and a second engaging portion extending outwardly from the second main body, and the second engaging portion comprising a second base extending from the second main body, and an inserting rib protruding outwardly from a lateral side of the second base;
wherein the inserting rib of the second fin is fitly inserted into the engaging groove of the first fin.

10. The heat sink as claimed in claim 9, wherein the first engaging portion extends along a lengthways direction of the first fin, the second engaging portion extends along the lengthways direction of the second fin, and the inserting rib extends along the lengthways direction of the second fin.

11. The heat sink as claimed in claim 9 or 10, wherein the inserting rib has a configuration in complement with that of the engaging groove.

12. The heat sink as claimed in claim 9, 10 or 11, wherein the first engaging portion of the first fin further comprises a protruding block formed in the engaging groove.

13. The heat sink as claimed in claim 12, wherein the second engaging portion of the second fin further comprises a cutout recessed inwardly from an outer periphery of the inserting rib, and the protruding block of the first fin is stuck in the cutout of the second fin.

14. The heat sink as claimed in claim 13, wherein the protruding block has a configuration in complement with that of the cutout.

15. The heat sink as claimed in claim 14, wherein the protruding block extends along a direction the engaging groove extends along, and the cutout extends along a direction which the inserting rib extends along.
